# EUROPEAN PATENT APPLICATION

(11) **EP 4 167 306 A1**
(43) Date of publication of application: **19.04.2023**
(21) Application number: 21821295.9
(22) Date of filing: 12.05.2021
(51) Int. Cl.: H01L 51/44, H01L 31/048

(54) **SOLAR CELL MODULE**

(30) Priority: 11.06.2020 JP 2020101919
(71) Applicant: Panasonic Intellectual Property Management Co., Ltd., Osaka-shi, Osaka 540-6207 (JP)
(72) Inventor: YAMAMOTO Teruaki, Osaka-shi, Osaka (JP)
(74) Representative: Grünecker Patent- und Rechtsanwälte PartG mbB
(86) International application number: PCT/JP2021/017968
(87) International publication number: WO 2021/251048

(57) **Abstract**

A solar cell module 100 according to the present disclosure includes a first substrate 101, a second substrate 102, a solar cell 103, an intermediate layer 104, and a first sealing layer 105. The first sealing layer 105 is disposed between the first substrate 101 and the second substrate 102 and seals the solar cell 103 and the intermediate layer 104 in an area between the first substrate 101 and the second substrate 102. The solar cell 103 has a laminate structure including a first electrode 107, a photoelectric conversion layer, and a second electrode 109. The intermediate layer 104 is not adhered to the main surface 103a of the solar cell 103. A softening temperature T1 of a material of the intermediate layer 104 is higher than a softening temperature T2 of a material of the first sealing layer 105.

## Description

### Technical Field

The present invention relates to a solar cell module.

### Background Art

In recent years, research and development have been underway for a perovskite solar cell. The perovskite solar cell includes, as a photoelectric conversion element, a compound (hereinafter referred to as a "perovskite compound") having a perovskite crystal structure represented by the composition formula ABX₃ (in which A is a monovalent cation, B is a divalent cation,
and X is a monovalent anion) or a similar crystal structure. Herein, a solar cell including the perovskite compound is referred to as a "perovskite solar cell."

NPL 1 discloses a basic structure of a perovskite solar cell. The perovskite solar cell having a basic structure includes, in this order, a transparent electrode, an electron transport layer, a photoelectric conversion layer (hereinafter referred to as a "perovskite layer") that has a perovskite crystal and performs photoelectric conversion and photoinduced separation, a hole transport layer, and a collective electrode. In other words, the electron transport layer (n), the perovskite layer (i), and the hole transport layer (p) are laminated in this order from the side of the transport electrode. This structure is called an n-i-p structure, or a regular lamination structure.

NPL 2 discloses a perovskite solar cell in which a hole transport layer, a perovskite layer, and an electron transport layer are laminated in this order from the side of the transport electrode. This structure is called a p-i-n structure, or an inverted lamination structure.

The solar cell is a device that receives sunlight to generate electricity, in other words, a device that uses sunlight as a power source. Thus, the solar cell is usually installed and used outdoors. This requires the solar cell to have a sealing structure called a solar cell module that enables the solar cell to resist outdoor environments, such as high temperatures, wind, and rain.

### Citation List

### Non Patent Literature

NPL 1: Julian Burchcka and six others, "Nature" (UK), July 2013, vol. 499, pp. 316-319
NPL 2: Wei Chen and ten others, "SCIENCE" (US), November 2015, vol. 350, no. 6263, pp. 944-948

### Summary of Invention

### Technical Problem

An object of the present disclosure is to provide a solar cell module having high durability.

### Solution to Problem

The present invention provides a solar cell module comprising:
a first substrate;
a second substrate disposed to face the first substrate;
a solar cell disposed on the first substrate and between the first substrate and the second substrate;
an intermediate layer disposed on a main surface of the solar cell that faces the second substrate; and
a first sealing layer disposed between the first substrate and the second substrate and sealing the solar cell and the intermediate layer in an area between the first substrate and the second substrate, wherein
the solar cell has a laminate structure including a first electrode, a photoelectric conversion layer, and a second electrode,
the intermediate layer is not adhered to the main surface of the solar cell, and
a softening temperature T1 of a material of the intermediate layer is higher than a softening temperature T2 of a material of the first sealing layer.

### Advantageous Effects of Invention

The present disclosure provides a solar cell module having high durability.

### Brief Description of Drawings

[Fig. 1A] Fig. 1A is a plan view illustrating a solar cell module according to a first embodiment.
[Fig. 1B] Fig. 1B is a cross-sectional view of the solar cell module taken along chain line I-I in Fig. 1A.
[Fig. 1C] Fig. 1C is a cross-sectional view of the solar cell module taken along chain line II-II in Fig. 1A.
[Fig. 2A] Fig. 2A is a cross-sectional view illustrating an example of a solar cell of the solar cell module according to the first embodiment.
[Fig. 2B] Fig. 2B is a cross-sectional view illustrating a modification of the solar cell of the solar cell module according to the first embodiment.
[Fig. 3A] Fig. 3A is a plan view illustrating a solar cell module according to a first comparative embodiment.
[Fig. 3B] Fig. 3B is a cross-sectional view of the solar cell module taken along chain line I-I in Fig. 3A.
[Fig. 4A] Fig. 4A is a plan view illustrating a solar cell module according to a second embodiment.
[Fig. 4B] Fig. 4B is a cross-sectional view of the solar cell module taken along chain line I-I in Fig. 4A.
[Fig. 4C] Fig. 4C is a cross-sectional view of the solar cell module taken along chain line II-II in Fig. 4A.
[Fig. 5A] Fig. 5A is a plan view illustrating a solar cell module according to a second comparative embodiment.
[Fig. 5B] Fig. 5B is a cross-sectional view of the solar cell module taken along chain line I-I in Fig. 5A.
[Fig. 6A] Fig. 6A is a plan view illustrating a solar cell module according to a third comparative embodiment.
[Fig. 6B] Fig. 6B is a cross-sectional view of the solar cell module taken along chain line I-I in Fig. 6A.

### Description of Embodiments

Hereinafter, embodiments of the present disclosure will be described in detail with reference to the drawings.

### (First Embodiment)

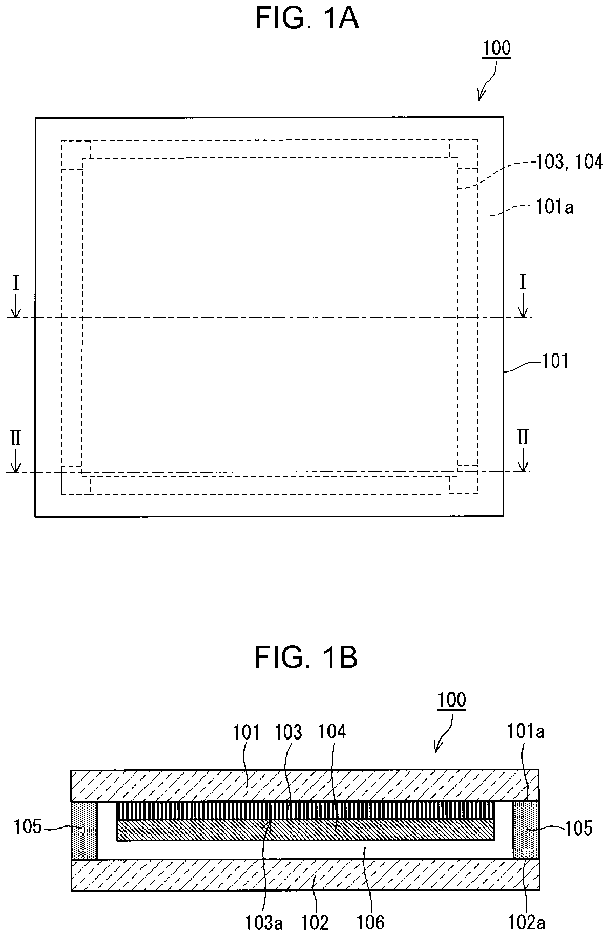

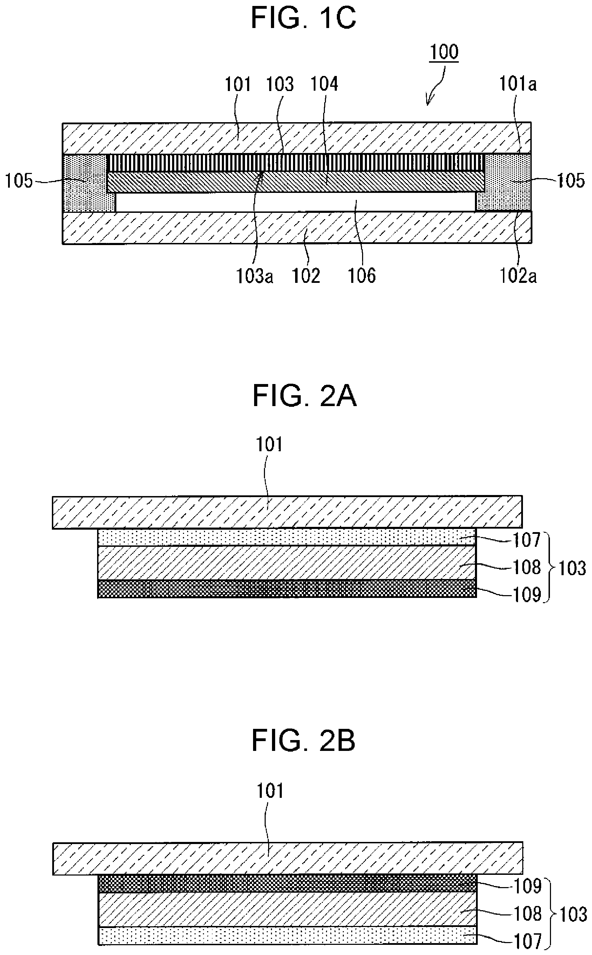

Fig. 1A is a plan view illustrating a solar cell module according to a first embodiment. Fig. 1B is a cross-sectional view of the solar cell module taken along chain line I-I in Fig. 1A. Fig. 1C is a cross-sectional view of the solar cell module taken along chain line II-II in Fig. 1A.

As illustrated in Figs. 1A, 1B, and 1C, a solar cell module 100 includes a first substrate 101, a second substrate 102, a solar cell 103, an intermediate layer 104, and a first sealing layer 105. The second substrate 102 is disposed to face the first substrate 101. The solar cell 103 is disposed on the first substrate 101 and between the first substrate 101 and the second substrate 102. The first sealing layer 105 is disposed between a peripheral portion 101a of the first substrate 101 and a peripheral portion 102a of the second substrate 102 and seals the solar cell 103 and the intermediate layer 104 in an area between the first substrate 101 and the second substrate 102. The intermediate layer 104 is disposed on a main surface 103a of the solar cell 103 that faces the second substrate 102. The intermediate layer 104 is in contact with the main surface 103a of the solar cell 103 but is not adhered to the main surface 103a of the solar cell 103. In other words, the intermediate layer 104 is positionally fixed in the solar cell module 100 so as to be in contact with the main surface 103a of the solar cell 103 without being adhered to the main surface 103a of the solar cell 103. For example, as illustrated in Fig. 1C, the intermediate layer 104 can be positionally fixed in the solar cell module 100 by a peripheral portion of the intermediate layer 104 at least partly fixed to the first sealing layer 105. Although not illustrated, the intermediate layer 104 may be fixed by the second substrate 102. In such a case, the intermediate layer 104 may be pressure bonded by the second substrate 102. The solar cell module 100 may have a space 106 between the intermediate layer 104 and the second substrate 102 as illustrated in Figs. 1B and 1C.

The first sealing layer 105 only has to be disposed between the first substrate 101 and the second substrate 102 and seal the solar cell 103 and the intermediate layer 104 in the area between the first substrate 101 and the second substrate.

Fig. 2A is a cross-sectional view illustrating an example of the solar cell 103 of the solar cell module 100 according to the first embodiment. Fig. 2B is a cross-sectional view illustrating a modification of the solar cell 103 of the solar cell module 100 according to the first embodiment. The solar cell 103 is a laminate including a photoelectric conversion layer 108 containing a perovskite compound, a first electrode 107, and a second electrode 109. For example, as illustrated in Fig. 2A, in the solar cell 103, the first electrode 107, the photoelectric conversion layer 108, and the second electrode 109 are laminated in this order from the side of the first substrate 101. In the solar cell 103, as illustrated in Fig. 2B, the second electrode 109, the photoelectric conversion layer 108, and the first electrode 107 may be laminated in this order from the side of the first substrate 101.

The solar cell 103 may further include another layer.

The solar cell 103 may have an electron transport layer between the first electrode 107 and the photoelectric conversion layer 108. In such a case, a porous layer may be further disposed between the electron transport layer and the photoelectric conversion layer 108.

The solar cell 103 may include a hole transport layer between the second electrode 109 and the photoelectric conversion layer 108.
Although not illustrated in Figs. 2A and 2B, the solar cell 103 may have a laminate structure in which the first electrode 107, the electron transport layer (not illustrated), the photoelectric conversion layer 108, the hole transport layer (not illustrated), and the second electrode 109 are laminated in this order. In the laminate structure, the positions of the electron transport layer and the hole transport layer may be switched.

The intermediate layer 104 may be formed of any material. For example, the material of the intermediate layer 104 is selected such that the material of the intermediate layer 104 has a softening temperature T1 that is higher than a softening temperature T2 of the material of the first sealing layer 105. This configuration enables the intermediate layer 104 to keep the shape during a heating process for forming the first sealing layer 105. For example, the softening temperature T1 may be higher than the softening temperature T2 by greater than or equal to 10°C, or by greater than or equal to 30°C. Here, in this specification, the softening temperature T1 of the material of the intermediate layer 104 and the softening temperature T2 of the material of the first sealing layer 105 are temperatures that do not allow the materials to keep the original shapes (for example, a sheet shape for the material of the intermediate layer 104) when the temperature is increased and that allow the materials to be soft enough to deform under pressure for sealing (for example, temperatures that allow the materials to be soft enough to conform to the shapes of the other components of the solar cell).

The material of the first sealing layer 105 may be a known solar cell module filler or a known solar cell module edge sealant. However, the perovskite solar cell 103 is relatively susceptible to high temperatures. Thus, it is preferable that the first sealing layer 105 be formed of a material that can be softened at a lower temperature to seal the area between the first substrate 101 and the second substrate 102. The softening temperature T2 of the material of the first sealing layer 105 is, for example, preferably less than or equal to 150°C, and more preferably less than or equal to 130 °C to reduce performance deterioration of the perovskite solar cell 103 caused by the heating for sealing. The lower limit of the softening temperature T2 of the material of the first sealing layer 105 is not limited to a particular temperature. However, in view of moisture resistance of the solar cell module 100, the softening temperature T2 is, for example, preferably greater than or equal to 120°C. The heating temperature (or the sealing temperature) for forming the first sealing layer 105 can be set, for example, at a temperature higher than the softening temperature T2 and may be set at a temperature higher than the softening temperature T2 by greater than or equal to 10°C or at a temperature higher than the softening temperature T2 by greater than or equal to 30°C.

Examples of the material of the first sealing layer 105 include polymers such as ethylene-vinyl acetate (or EVA), polyolefins (or PO) and butyl rubber, and silicone rubber.

A material for the intermediate layer 104 in a sheet-like form, or a sheet material, may be used to produce the intermediate layer 104.

As described above, the material of the intermediate layer 104 only has to have the softening temperature T1 higher than the softening temperature T2 of the first sealing layer 105. However, it is preferable that the material is less likely to emit a gas, change in volume, undergo chemical change, and undergo softening during production or use of the solar cell module 100.

Examples of the material of the intermediate layer 104 include glass and a polymer compound.

An example of the polymer compound used as a material of the intermediate layer 104 is polyethylene. The specific gravity of polyethylene or the like is about 1 and is smaller than the specific gravity of glass (for example, 2.5). Thus, the solar cell module 100 including the intermediate layer 104 formed of a polymer can have a smaller total weight per strength.

Hereinafter, basic operational effects of the components of the solar cell module 100 will be described.

When the solar cell 103 is irradiated with light, the photoelectric conversion layer 108 absorbs the light, and excited electrons and holes are generated. The excited electrons move to the first electrode 107 (or the electron transport layer). The hole generated at the photoelectric conversion layer 108 moves to the second electrode 109 (or the hole transport layer). The current can be drawn using the first electrode 107 coupled to the electron transport layer as a negative electrode and using the second electrode 109 coupled to the hole transport layer as a positive electrode.

The solar cell module 100 includes the intermediate layer 104 between the first substrate 101 and the second substrate 102. The intermediate layer 104 improves the mechanical strength of the solar cell module 100. The intermediate layer 104 is positionally fixed in the solar cell module 100, for example, by being fixed to the second substrate 102 or the first sealing layer 105, without being adhered to the main surface 103a of the solar cell 103. Thus, when the intermediate layer 104 is displaced by warping caused during the sealing operation or during use, the stress is not directly applied to the interfaces of the layers of the solar cell 103. This reduces delamination of the solar cell 103 at the interfaces where bonding strength between the layers is weak. In addition, the intermediate layer 104 not adhered to the main surface 103a of the solar cell 103 does not prevent the gas molecules from moving at the interface between the intermediate layer 104 and the solar cell 103. In other words, the gas molecules are allowed to move at the interface between the intermediate layer 104 and the solar cell 103 in a planar direction. Thus, the desorbed gas generated from the solar cell 103 is less likely to stay between the solar cell 103 and the intermediate layer 104 at a high concentration. This results in reduction of deterioration of the solar cell properties. The desorbed gas is derived from the materials constituting the solar cell 103. Here, the phrase "the intermediate layer 104 is disposed on the main surface 103a of the solar cell 103 without being adhered thereto" means that the intermediate layer 104 is detachably disposed on the main surface 103a of the solar cell 103.

As described above, the solar cell module 100 according to the first embodiment can have the high durability.

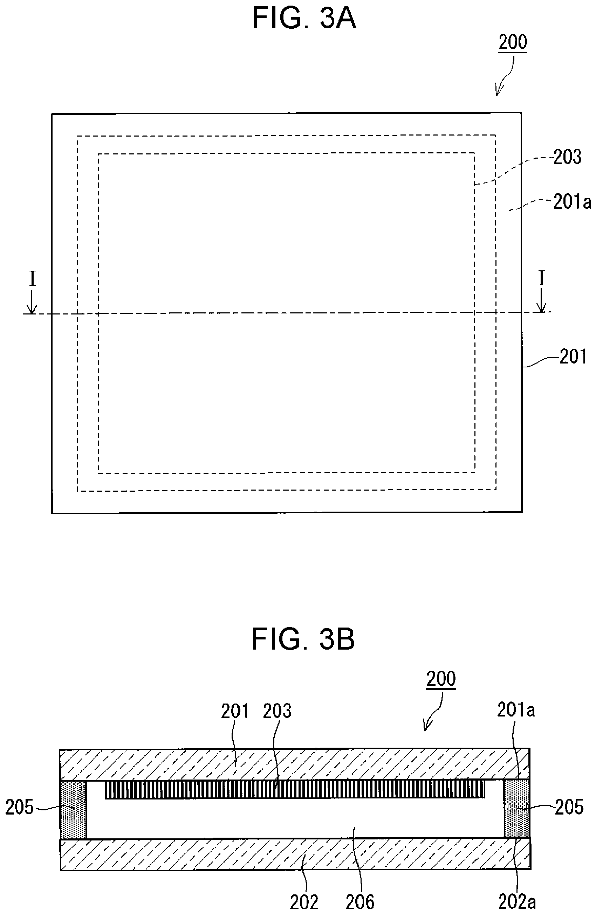

Fig. 3A is a plan view illustrating a solar cell module according to a first comparative embodiment. Fig. 3B is a cross-sectional view of the solar cell module taken along chain line I-I in Fig. 3A.

A solar cell module 200 according to a first comparative embodiment does not include the intermediate layer 104, which is included in the solar cell module 100 of the first embodiment. The first substrate 201, the peripheral portion 201a of the first substrate, the second substrate 202, the peripheral portion 202a of the second substrate, the solar cell 203, the first sealing layer 205, and the space 206 of the solar cell module 200 are the same as the first substrate 101, the peripheral portion 101a of the first substrate, the second substrate 102, the peripheral portion 102a of the second substrate, the solar cell 103, the first sealing layer 105, and the space 106 of the solar cell module 100, respectively. Thus, the components will not be described in detail here.

The solar cell module 200 not including the intermediate layer needs to have a thicker first substrate 201 and a thicker second substrate 202 to keep the load bearing. However, the thicker first substrate 201 and the thicker second substrate 202 create disadvantages of an increase in the total weight and an increase in the light absorption loss at the substrate having the light-receiving surface (here, the first substrate 201).

The solar cell module 100 according to the first embodiment can be produced, for example, by the following method. Here, the method of producing one including the solar cell 103 having the configuration illustrated in Fig. 2A will be described.

First, the first electrode 107 is formed on the surface of the first substrate 101. Next, the electron transport layer is formed, for example, by a sputtering method on the first electrode 107 on the first substrate 101. Next, the photoelectric conversion layer 108 is formed, for example, by a coating process on the electron transport layer. Next, the hole transport layer is formed, for example, by a coating process on the photoelectric conversion layer 108. Next, the second electrode 109 is formed, for example, by vapor deposition on the hole transport layer.

The solar cell 103 is formed on the first substrate 101 by the above-described processes.

Next, the intermediate layer 104 is placed on the solar cell 103 on the first substrate 101 without being bonded to the solar cell 103. The second substrate 102 is placed to face the first substrate 101 with the solar cell 103 therebetween, and the first sealing layer 105 is placed between the peripheral portion 101a of the first substrate 101 and the peripheral portion 102a of the second substrate 102. This forms the laminate including the first substrate 101, the solar cell 103, the intermediate layer 104, the first sealing layer 105, and the second substrate 102. In this laminate, the corner of the intermediate layer 104 is fixed to the first sealing layer 105, and thus the intermediate layer 104 is positionally fixed.

The laminate is unified by integral formation such as thermal pressure bonding and the peripheral portion is sealed by the first sealing layer 105 at the same time. This can form the solar cell module 100.

Hereinafter, the components of the solar cell module 100 will be described in detail.

### [First Substrate 101]

The first substrate 101 is placed on the light-receiving side of the solar cell module 100. The first substrate 101 has, for example, water vapor barrier properties and light transmitting properties. The first substrate 101 may be transparent. Furthermore, the first substrate 101 physically holds the layers of the solar cell 103 as films during production of the solar cell module 100. Examples of the first substrate 101 include a glass substrate and a plastic substrate. The plastic substrate may be a plastic film.

### [Second Substrate 102]

The second substrate 102 is disposed to face the first substrate 101 of the solar cell module 100. The second substrate 102 has, for example, water vapor barrier properties. The second substrate 102 further functions as a protector for the solar cell 103. The second substrate 102 can reduce a physical damage to the solar cell 103 caused, for example, by an external factor such as sand grains. Examples of the second substrate 102 include a glass substrate and a plastic substrate. The plastic substrate may be a plastic film. The second substrate 102 does not necessarily have light transmitting properties. Thus, an Al deposited film may be used as the second substrate 102 when the first substrate 101 itself has sufficient strength or when the internal space filled with the second sealing layer 110 provides sufficient strength.

### [Electron Transport Layer]

The electron transport layer includes, for example, a semiconductor. The electron transport layer may contain a semiconductor having a bandgap of greater than or equal to 3.0 eV. The electron transport layer formed of a semiconductor having a bandgap of greater than or equal to 3.0 eV enables visible light and infrared light to be transmitted to the photoelectric conversion layer 108. Examples of the semiconductor include organic n-type semiconductors and inorganic n-type semiconductors.

Examples of the organic n-type semiconductor include imide compounds, quinone compounds, fullerenes, and fullerene derivatives. Examples of the inorganic n-type semiconductors include metal oxides and perovskite oxides. Examples of the metal oxides include oxides of Cd, Zn, In, Pb, Mo, W, Sb, Bi, Cu, Hg, Ti, Ag, Mn, Fe, V, Sn, Zr, Sr, Ga, Si, and Cr. Specific examples include titanium oxide (or TiOz). Examples of the perovskite oxides include SrTiO₃ and CaTiO₃.

### [Photoelectric Conversion Layer 108]

The photoelectric conversion layer 108 includes a perovskite compound. As described above, the perovskite compound is a perovskite crystal structure represented by the composition formula ABX₃ or a structure having a crystal similar to that. A is a monovalent cation, B is a divalent cation, and X is a monovalent anion. Examples of the monovalent cation A include an alkali metal cation and an organic cation. Specific examples of the cation A include methylammonium cation (CH₃NH₃⁺), formamidinium cation (NH₂CHNH₂⁺), cesium cation (Cs⁺), and rubidium cation (Rb⁺). Examples of cation B include a transition metal and divalent Group 13 to Group 15 element cation. Specific examples of the cation B include Pb²⁺, Ge²⁺, and Sn²⁺. Examples of the anion X include a halogen anion. The sites of A, B, and X each may be occupied by multiple kinds of ions. Examples of the compound having the perovskite structure include CH₃NH₃Pbl₃, CH₃CH₂NH₃Pbl₃, NH₂CHNH₂Pbl₃, CH₃NH₃PbBr₃, CH₃NH₃PbCl₃, CsPbl₃, CsPbBr₃, RbPbl₃, RbPbBr₃, and combinations of the compositions. The photoelectric conversion layer 108 may be a perovskite compound that is a structure similar to the perovskite structure represented by the composition formula ABX₃. Examples of the similar structure include a structure that is a perovskite compound containing a halogen anion defect or a structure that is a perovskite compound including a monovalent cation or a halogen anion constituted by multiple kinds of elements.

The photoelectric conversion layer 108 may have a thickness of greater than or equal to 100 nm and less than or equal to 1000 nm. The thickness of the photoelectric conversion layer 108 may depend on the light absorption level of the photoelectric conversion layer 108.

The photoelectric conversion layer 108 can be formed by a coating process using a solution or a co-deposition process, for example. Furthermore, the photoelectric conversion layer 108 may be partly mixed with the electron transport layer.

### [Hole Transport Layer]

The hole transport layer is formed of, for example, an organic semiconductor or an inorganic semiconductor. The hole transport layer may include a plurality of layers formed of the same material or may alternately include plurality of layers formed of different materials. Examples of the organic semiconductors include polytriarylamine (PTAA), 2,2',7,7'-tetrakis(N,N'-di-p-methoxyphenylamine)-9-9'-spirobifluorene (Spiro-OMeTAD), and poly(3,4-ethylenedioxythiophene) (PEDOT). Examples of the inorganic semiconductors include p-type inorganic semiconductors. Examples of the p-type inorganic semiconductors include CuO, CuzO, CuSCN, molybdenum oxide, and nickel oxide.

### [Intermediate Layer 104]

The details of the intermediate layer 104 such as the materials forming the intermediate layer 104 are as described above.

### [First Sealing Layer 105]

The details of the first sealing layer 105 such as the materials forming the first sealing layer 105 are as described above.

### (Second Embodiment)

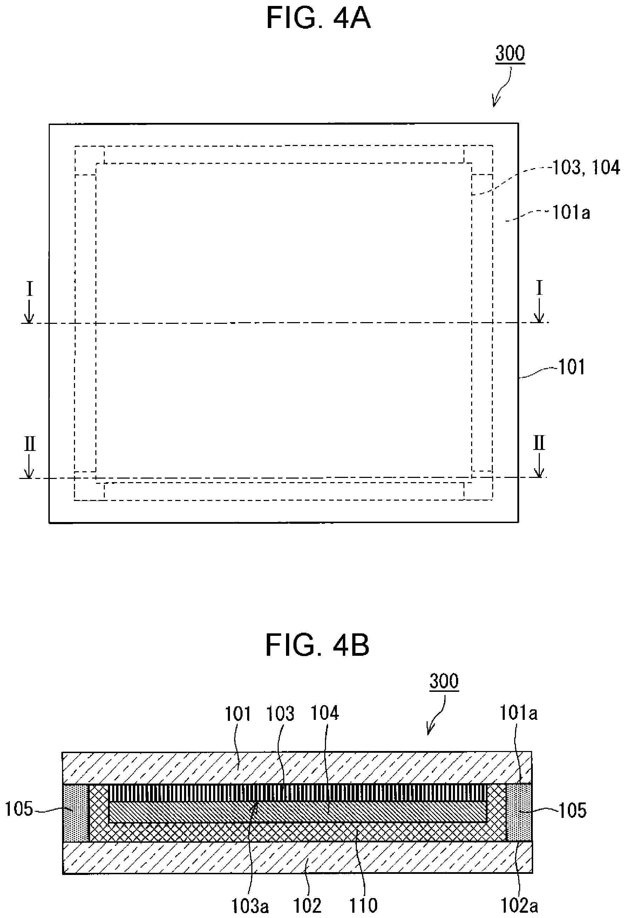

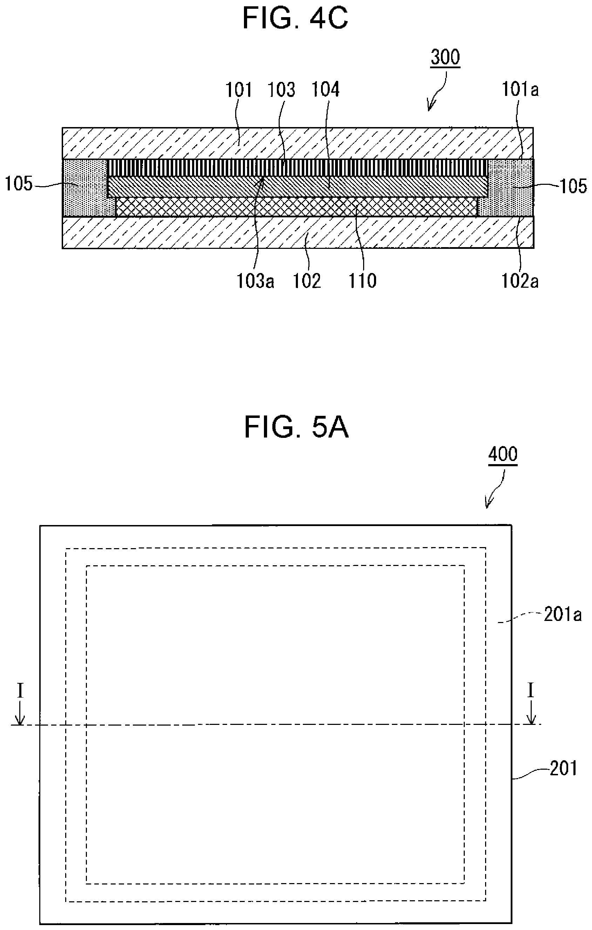

Fig. 4A is a plan view illustrating a solar cell module according to a second embodiment. Fig. 4B is a cross-sectional view of the solar cell module taken along chain line I-I in Fig. 4A. Fig. 4C is a cross-sectional view of the solar cell module taken along chain line II-II in Fig. 4A.

The solar cell module 300 illustrated in Figs. 4A, 4B, and 4C includes a second sealing layer 110 instead of the space 106, which is included in the solar cell module 100 of the first embodiment. The solar cell module 300 has the same configuration as the solar cell module 100 except for this. In view of the moisture resistance and the load bearing, the second sealing layer 110 is preferable to the space 106 to be provided between the intermediate layer 104 and the second substrate 102. The second sealing layer 110 decreases the diffusion rate of water entered the module, leading to an improvement of the moisture resistance. This results in further improvement of the durability of the solar cell module.

The material of the second sealing layer 110 may be a known solar cell module filler. However, the softening temperature T3 of the material of the second sealing layer 110 is lower than the softening temperature T1 of the intermediate layer 104. Furthermore, the perovskite solar cell 103 is relatively susceptible to high temperatures. Thus, it is preferable that the second sealing layer 110 be softened at a lower temperature to seal between the first substrate 101 and the second substrate 102. The softening temperature T3 of the material of the second sealing layer 110 is, for example, preferably less than or equal to 150°C, and more preferably less than or equal to 130°C to reduce the possibility that the performance of the perovskite solar cell 103 will be lowered by the heat for sealing. The lower limit of the softening temperature T3 of the material of the second sealing layer 110 is not particularly limited. However, the softening temperature T3 is preferably greater than or equal to 90°C, for example, in view of that the temperature of the solar cell module 300 being used can reach about 80°C. When the first sealing layer 105 and the second sealing layer 110 are formed at the same time in the same heating process, the sealing temperature is set at a temperature higher than the higher one of the softening temperature T2 of the first sealing layer 105 and the softening temperature T3 of the second sealing layer 110.

Examples of the material of the second sealing layer 110 include a polymer compound such as EVA and PO.

As in the solar cell module 100, in the solar cell module 300, the intermediate layer 104 is disposed to be in contact with the main surface 103a of the solar cell 103 but is not adhered to the main surface 103a of the solar cell 103. In other words, the intermediate layer 104 is positionally fixed in the solar cell module 300 so as to be in contact with the main surface 103a of the solar cell 103 without being adhered to the main surface 103a of the solar cell 103. For example, as illustrated in Fig. 4C, the intermediate layer 104 can be positionally fixed in the solar cell module 300 by the peripheral portion of the intermediate layer 104 at least partly fixed to the first sealing layer 105. Although not illustrated, the intermediate layer 104 may be fixed by the second substrate 102 or the second sealing layer 110. In such a case, the intermediate layer 104 may be pressure bonded by the second substrate 102 or the second sealing layer 110.

The solar cell module 300 includes the intermediate layer 104 and thus the operational effects thereof are the same as those of the solar cell module 100 described in the first embodiment.

The intermediate layer 104 on the main surface 103a of the solar cell 103 provides the solar cell module 300 with another operational effect of less interfacial delamination of the layers of the solar cell 103. The interfaces of the layers of the solar cell 103 include, for example, an interface between the photoelectric conversion layer 108 and the hole transport layer, an interface between the photoelectric conversion layer 108 and the electron transport layer, an interface between the hole transport layer and the second electrode 109, and an interface between the electron transport layer and the first electrode 107. This operational effect will be described in further detail.

For example, after the second sealing layer 110 fills a space between the first substrate 101 and the second substrate 102, a thermal pressure bonding process is typically performed to unify the solar cell module 300. In this case, first, a material of the second sealing layer 110 is placed in a space between the first substrate 101 having the solar cell 103 thereon and the second substrate 102 facing the first substrate 101. Then, a material of the first sealing layer 105 is placed around the second sealing layer 110. This produces a laminate including the first substrate 101, the solar cell 103, the intermediate layer 104, the first sealing layer 105, the second sealing layer 110, and the second substrate 102. Next, the material of the second sealing layer 110 and the material of the first sealing layer 105 are softened by heating, and the entire laminate is pressure bonded to unify the first substrate 101, the solar cell 103, the intermediate layer 104, the second sealing layer 110, and the second substrate 102. As the same time, the peripheral portion 101a of the first substrate 101 and the peripheral portion 102a of the second substrate 102 are integrated with the first sealing layer 105, and sealing is done.

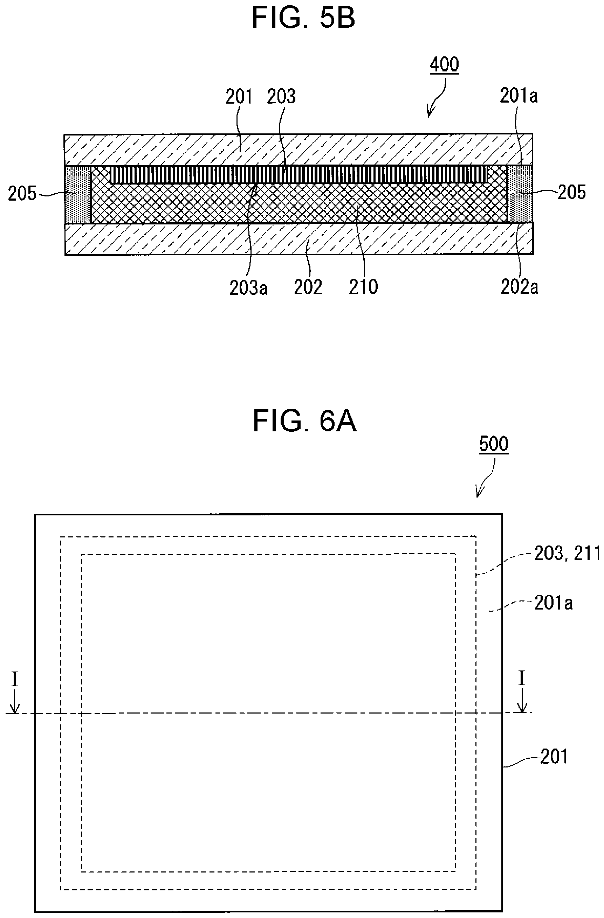

Here, a solar cell module according to a second comparative embodiment is described in which the intermediate layer 104, which is included in the solar cell module 300, is not included. Fig. 5A is a plan view illustrating the solar cell module according to the second comparative embodiment. Fig. 5B is a cross-sectional view of the solar cell module taken along chain line I-I in Fig. 5A. The first substrate 201, the peripheral portion 201a of the first substrate, the second substrate 202, the peripheral portion 202a of the second substrate, the solar cell 203, the first sealing layer 205, and the second sealing layer 210 of the solar cell module 400 are the same as the first substrate 101, the peripheral portion 101a of the first substrate, the second substrate 102, the peripheral portion 102a of the second substrate, the solar cell 103, the first sealing layer 105, and the second sealing layer 110 of the solar cell module 300, respectively. Thus, the components will not be described in detail. The solar cell module 400 according to the second comparative embodiment includes the solar cell 203 having the main surface 203a in contact with the second sealing layer 210. In this configuration, when the material of the second sealing layer 210 is softened by heating for pressure bonding of the laminate, delamination may occur at the interfaces of the solar cell 203 where the bonding strength between the layers is weak, for example, due to dragging by the flow of the material of the second sealing layer 210. The interfaces include, for example, an interface between the photoelectric conversion layer 208 and the hole transport layer, an interface between the photoelectric conversion layer 208 and the electron transport layer, an interface between the hole transport layer and the second electrode 209, and an interface between the electron transport layer and the first electrode 207.

In contrast, the solar cell module 300 includes the intermediate layer 104 between the main surface 103a of the solar cell 103 and the second sealing layer 110. The intermediate layer 104 is formed of a material having a softening temperature higher than that of the first sealing layer 105 and that of the second sealing layer 110. In this configuration, during the pressure bonding of the laminate with the material of the second sealing layer 110 being softened by heating, the intermediate layer 104 is interposed between the main surface 103a of the solar cell 103 and the second sealing layer 110. This reduces the delamination of the layers of the solar cell 103, which may be caused when the layers are dragged by the flow of the second sealing layer 110. Furthermore, the intermediate layer 104 that is not adhered to the main surface 103a of the solar cell 103 does not prevent the movement of gas molecules at the interface between the intermediate layer 104 and the solar cell 103. Thus, the desorbed gas generated from the solar cell 103 is less likely to stay between the solar cell 103 and the intermediate layer 104 at a high concentration. This results in reduction of deterioration of the solar cell properties. The desorbed gas is derived from the materials constituting the solar cell 103. The desorbed gas can be diffused in the entire second sealing layer 110.

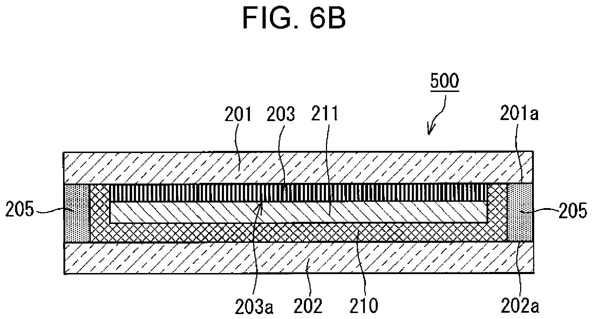

Furthermore, another comparative embodiment will be examined. Fig. 6A is a plan view illustrating a solar cell module according to a third comparative embodiment. Fig. 6B is a cross-sectional view of the solar cell module taken along chain line I-I in Fig. 6A.

The solar cell module 500 according to the third comparative embodiment further includes an intermediate layer 211 formed by a vapor deposition process on a main surface 203a of the solar cell 203, in addition to the components of the solar cell module 400 according to the second comparative embodiment. In other words, the solar cell module 500 according to the third comparative embodiment differs from the solar cell module 300 according to the second embodiment in that the intermediate layer is adhered to the main surface of the solar cell.

The solar cell module 500 according to the third comparative embodiment includes the intermediate layer 211 adhered to the main surface 103a of the solar cell 203. This prevents gas molecules from moving at the interface between the intermediate layer 211 and the solar cell 203 in the solar cell module 500. Thus, the desorbed gas generated from the solar cell 203 can stay between the solar cell 203 and the intermediate layer 211 at a high concentration. This results in deterioration of the solar cell properties.

As described above, the solar cell module 300 according to the second embodiment in which the intermediate layer 104 is disposed on the solar cell 103 without being adhered thereto can have advantages of reduction in interfacial delamination of the layers of the multilayer structure constituting the solar cell 103, less deterioration caused by the desorbed gas that stays on the solar cell surface, and load bearing of the light-weight module, in addition to the improvement in the mechanical strength of the solar cell module 300.

As described above, the solar cell module 300 according to the second embodiment can have high durability.

The solar cell module 300 can be produced by the following method, for example.

The method is the same as the method of forming the solar cell module 100 according to the first embodiment up to the formation of the solar cell 103 on the first substrate 101.

Next, the intermediate layer 104 is placed on the solar cell 103 on the first substrate 101 without being adhered to the solar cell 103. The second substrate 102 is placed to face the first substrate 101 with the solar cell 103 therebetween, the second sealing layer 110 is placed between the intermediate layer 104 and the second substrate 102, and the first sealing layer 105 is placed between the peripheral portion 101a of the first substrate 101 and the peripheral portion 102a of the second substrate 102. This forms the laminate including the first substrate 101, the solar cell 103, the intermediate layer 104, the second sealing layer 110, the first sealing layer 105, and the second substrate 102. In this laminate, the intermediate layer 104 is positionally fixed by the corner of the intermediate layer 104 fixed to the first sealing layer 105 and by the second sealing layer 110.

The laminate is unified by integral formation such as thermal pressure bonding and a space between the first substrate 101 and the second substrate 102 and the peripheral portion are sealed by the first sealing layer 105 and the second sealing layer 110 at the same time. This can form the solar cell module 300.

### EXAMPLES

The present disclosure will be described in more detail with reference to the following examples.

Solar cell modules of Examples 1 to 4 and Comparative Examples 1 to 4 were produced, and the properties of the solar cell modules were evaluated.

First, configurations of the solar cell modules of Examples and Comparative Examples and methods of producing the same are described.

### [Example 1]

A solar cell module of Example 1 has the same structure as the solar cell module 100 illustrated in Figs. 1A, 1B, and 1C. The materials, sizes, and thicknesses of the components of the solar cell module of Example 1 are indicated below.

First substrate 101: a glass substrate with a fluorine doped SnOz layer (available from Nippon Sheet Glass Co., Ltd., thickness of 0.7 mm, surface resistance of 10 Ω/sq.)
·Electron transport layer: titanium oxide (thickness of 30 nm), porous titanium oxide (thickness of 200 nm)
·Photoelectric conversion layer 108: a perovskite compound (thickness of 300 nm)
·Hole transport layer: PTAA (available from Aldrich)
·Second substrate 102: a glass substrate (thickness of 0.7 mm)
·First sealing layer 105: butyl rubber (thickness of 0.8 mm)
·Intermediate layer 104: a glass substrate (softening temperature T1: greater than 450°C, thickness of 0.5 mm)

The method of producing the solar cell module of Example 1 is as follows.

A conductive glass substrate having a thickness of 0.7 mm and having a fluorine doped SnOz layer on the main surface was provided. This substrate was used as the first substrate 101. The fluorine doped SnOz layer of the conductive glass substrate was used as the first electrode 107.

A titanium oxide layer having a thickness of about 30 nm and a porous titanium oxide layer having a thickness of 0.2 µm were formed as an electron transport layer on the first electrode 107 of the first substrate 101. The titanium oxide layer was formed on the first electrode 107 of the first substrate 101 by a sputtering method. A titanium oxide paste was applied onto the titanium oxide layer and dried, and the dried film was heat-treated at 500°C for 30 minutes in the air to form the porous titanium oxide layer. The titanium oxide paste was prepared by dispersing high-purity titanium oxide powder having an average primary particle diameter of 20 nm in ethyl cellulose.

Next, a raw material solution of the photoelectric conversion material was applied onto the electron transport layer to form the photoelectric conversion layer 108 containing the perovskite compound. The raw material solution is a solution containing 0.92 mol/L of lead(II) iodide (available from Tokyo Chemical Industry Co., Ltd.), 0.17 mol/L of lead(II) bromide (available from Tokyo Chemical Industry Co., Ltd.), 0.83 mol/L of formamidinium iodide (available from GreatCell Solar), 0.17 mol/L of methylammonium bromide (available from GreatCell Solar), 0.05 mol/L of cesium iodide (available from Iwatani Corporation), and 0.05 mol/L of rubidium iodide (available from Iwatani Corporation). The solvent for the solution was a mixture of dimethyl sulfoxide (available from acros) and N,N-dimethylformamide (available from acros). A mixture ratio (DMSO:DMF) of dimethyl sulfoxide (DMSO) and N,N-dimethylformamide (DMF) was 1:4 (volume ratio). Then, the formed coating film was thermally treated at 115°C for 15 minutes and at 100°C for 30 minutes on a hot plate, and thus a layer having a perovskite structure was produced as the photoelectric conversion layer 108.

Next, a toluene solution containing 10 mg/mL of PTAA, 5 mmol/L of lithium bis(fluorosulfonyl)imide (LiTFSI), and 6 µL/mL of tert-butylpyridine (tBP) was applied onto the photoelectric conversion layer 108 by spin coating, and thus the hole transport layer was produced.

Gold was vapor deposited on the hole transport layer to form a layer of 150 nm as the second electrode 109.

The solar cell 103 was formed on the first substrate 101 as above.

Next, a glass substrate having a thickness of 0.5 mm as the intermediate layer 104 was placed on the solar cell 103 on the first substrate 101 without being adhered to the solar cell 103. A glass substrate having a thickness of 0.7 mm as the second substrate 102 was placed to face the first substrate 101 with the solar cell 103 therebetween, and the first sealing layer 105 was further placed between the peripheral portion 101a of the first substrate 101 and the peripheral portion 102a of the second substrate 102. This forms a laminate including the first substrate 101, the solar cell 103, the intermediate layer 104, the first sealing layer 105, and the second substrate 102. The corner of the intermediate layer 104 was fixed to the first sealing layer 105 to positionally fix the intermediate layer 104. The laminate was subjected to thermal pressure bonding by using a vacuum lamination process to produce the solar cell module 100. The heating temperature (or sealing temperature) at the pressure bonding was 120°C. In the pressure bonding, at 120°C, deaeration was performed for 180 seconds, and pressure was applied to the laminate in the lamination direction at 20 MPa for 300 seconds.

### [Example 2]

The solar cell module of Example 1 in which PO is further disposed as a second sealing layer 110 between the intermediate layer 104, which is disposed on the solar cell 103 on the first substrate 101 without being adhered thereto, and the second substrate 102, was produced as a solar cell module of Example 2. The softening temperature of PO is 90°C.

### [Example 3]

The solar cell module of Example 2 in which EVA is disposed instead of PO as the second sealing layer 110 was produced as a solar cell module of Example 3. The softening temperature of EVA is 130 °C, and thus the pressure bonding was performed at 130°C.

### [Example 4]

The solar cell module of Example 2 in which a polyethylene plate (softening temperature T1: 140°C) having a thickness of 0.5 mm is disposed as the intermediate layer 104, instead of the glass plate, was produced as a solar cell module of Example 4.

### [Comparative Example 1]

The solar cell module of Example 1 in which the intermediate layer 104 is not disposed was produced as a solar cell module of Comparative Example 1.

### [Comparative Example 2]

The solar cell module of Example 2 in which the intermediate layer 104 is not disposed was produced as a solar cell module of Comparative Example 2.

### [Comparative Example 3]

The solar cell module of Example 3 in which the intermediate layer 104 is not disposed was produced as a solar cell module of Comparative Example 3.

### [Comparative Example 4]

In the solar cell module of Example 2, instead that a glass substrate is disposed on the solar cell 103 to form the intermediate layer 104, a SiOz film having a thickness of 100 nm was directly formed on the solar cell 103 by a vapor deposition process to form the intermediate layer 104. In this way, a solar cell module of Comparative Example 4 was produced.

### [Evaluation Method]

Properties and moisture resistances of the solar cell modules before and after the sealing were evaluated. The solar cell module was irradiated with light having illuminance of 100 mW/cm² by using a halogen lamp ("BPS X300BA" available from Bunkoukeiki Co., Ltd.), and a current-voltage characteristic after stabilization was measured by using "ALS440B" available from BAS Inc. to determine the properties of the solar cell module. This enables calculation of the conversion efficiency of each of the solar cell modules.

In the evaluations of the properties before and after sealing, the retention rate after sealing is a relative value of the conversion efficiency after sealing, with the conversion efficiency before sealing being defined as 100. The retention rate after sealing was determined to be effective when showing greater than or equal to 95% and was determined to be fully effective when showing greater than or equal to 99%.

In the evaluation of moisture resistance, the solar cell module was left at 85°C and 85% relative humidity for 1000 hours, and the properties of the solar cell module before and after being left were compared. The retention rate after the moisture resistance test is a relative value of the conversion efficiency after the moisture resistance test, with the conversion efficiency before the moisture resistance test being defined as 100. The retention rate after the moisture resistance test was determined to be effective when showing greater than or equal to 95% and determined to be fully effective when showing greater than or equal to 99%.

The load bearing was evaluated by visually checking the presence or absence of crack and deformation after pressure bonding in the module production.

Table 1 shows the results.

**[Table 1]**

| | Intermediate Layer | Second Sealing Layer | Intermediate Layer Adhesion | Intermediate Layer Softening Temp. T1 | Second Sealing Layer Softening Temp. T3 | Sealing Temp. | Retention Rate After Sealing | Retention Rate After Moisture Resistance Test | Load Bearing |
|---|---|---|---|---|---|---|---|---|---|
| Ex. 1 | glass plate | none | none | > 450°C | N/A | 120°C | 100 | 97% | no crack |
| | | | | | | | | | slight deformation |
| Ex. 2 | glass plate | PO | none | > 450°C | 90°C | 120°C | 99 | 99% | no crack |
| | | | | | | | | | no deformation |
| Ex. 3 | glass plate | EVA | none | > 450°C | 130°C | 130°C | 95 | 97% | no crack |
| | | | | | | | | | no deformation |
| Ex. 4 | polyethylene plate | PO | none | 140°C | 90°C | 120°C | 99 | 99% | no crack |
| | | | | | | | | | no deformation |
| Com. Ex. 1 | none | none | N/A | N/A | N/A | 120°C | 100 | 97% | many cracks |
| | | | | | | | | | large deformation |
| Com. Ex. 2 | none | PO | N/A | N/A | 90°C | 120°C | 74 | 68% | no crack |
| | | | | | | | | | no deformation |
| Com. Ex. 3 | none | EVA | N/A | N/A | 130°C | 130°C | 82 | 86% | no crack |
| | | | | | | | | | no deformation |
| Com. Ex. 4 | SiO₂ deposition | PO | yes | > 450°C | 90°C | 120°C | 92 | 98% | no crack |
| | | | | | | | | | no deformation |

First, attention is focused on the retention rates after sealing. The solar cell modules of Example 1, Example 4, and Comparative Example 1, each of which does not include the second sealing layer 110, are each free from interfacial delamination of the solar cell 103 and thus have the retention rate after sealing of greater than or equal to 99%. In contrast, the solar cell modules of Comparative Examples 2 and 3, each of which does not include the intermediate layer 104 and include the second sealing layer 110, have a significant reduction in the retention rate after sealing, and it was confirmed that the influence of the interfacial delamination in the solar cell 103 during the thermal pressure bonding for sealing is large.

The solar cell module of Comparative Example 4 in which the SiOz deposited film was used as the intermediate layer 104 has the retention rate after sealing of less than 95%. In the solar cell module of Comparative Example 4, interfacial delamination was not found in the solar cell 103. However, since the intermediate layer 104 is adhered to the solar cell 103, this may be due to the influence of the desorbed gas from the solar cell 103 that stays at a high concentration.

The retention rate after sealing of the solar cell modules of Examples 2 and 3, each of which includes the intermediate layer 104 not adhered to the solar cell 103, was largely improved compared to that of the solar cell modules of Comparative Examples 2 and 3, each of which does not include the intermediate layer 104, and that of the solar cell module of Comparative Example 4, which includes the intermediate layer 104 adhered to the solar cell 103. This may result from that the solar cell modules of Examples 2 and 3 had less interfacial delamination of the solar cell 103 and were not affected by accumulation of the desorbed gas from the solar cell 103.

Next, attention is focused on the retention rate after the moisture resistance test. The second sealing layer 110 of the solar cell module of Comparative Examples 2 and 3, which is an additional component to the solar cell module of Comparative Example 1, was expected to reduce diffusion of moisture entered the module, but the properties were further largely deteriorated, because interfacial delamination was progressed by heat of the moisture resistance test. The solar cell module of Comparative Example 4 had deterioration in the properties after sealing, but the retention rate after the moisture resistance test was good.

The second sealing layer 110 of the solar cell module of Example 2, which is an additional component to the solar cell module of Example 1, reduced diffusion of moisture entered the module and was sufficiently effective to improve the retention rate after the moisture resistance test. The same effect was expected for the solar cell module of Example 3, but the retention rate after the moisture resistance test of Example 3 was the same as that of Example 1. In Example 3, the sealing temperature was higher because the softening point of the second sealing layer 110 was higher, and thus the solar cell 103 was probably damaged a little unlike Example 2.

Example 4 in which the polyethylene plate was used instead of the glass substrate as the intermediate layer 104 in Example 2 has a smaller weight and showed the retention rate after the moisture resistance test equivalent to that of Example 2.

Finally, attention is focused on the load bearing. In the solar cell module of Comparative Example 1 including none of the intermediate layer 104 and the second sealing layer 110, the first substrate 101 and the second substrate 102 each largely deformed to the inner side of the module and had cracks over a large area of the substrates. Comparative Example 2 to 4 not including the intermediate layer 104 but including the second sealing layer 110 did not crack or deform.

Unlike the solar cell module of Comparative Example 1, Example 1 including the intermediate layer 104 less deformed and did not crack in the substrate. The solar cell modules of Examples 2 to 4, which include both the second sealing layer 110 and the intermediate layer 104, did not crack or deform.

### Industrial Applicability

The solar cell module according to the present disclosure is widely used as a device for a power generation system that converts sunlight into electricity.

### Reference Signs List

101, 201 first substrate
102, 202 second substrate
103, 203 solar cell
103a, 203a main surface
104, 211 intermediate layer
105, 205 first sealing layer
106, 206 space
107 first electrode
108 photoelectric conversion layer
109 second electrode
110, 210 second sealing layer
100, 200, 300, 400, 500 solar cell module

## Claims

1. A solar cell module comprising:
a first substrate;
a second substrate disposed to face the first substrate;
a solar cell disposed on the first substrate and between the first substrate and the second substrate;
an intermediate layer disposed on a main surface of the solar cell that faces the second substrate; and
a first sealing layer disposed between the first substrate and the second substrate and sealing the solar cell and the intermediate layer in an area between the first substrate and the second substrate, wherein
the solar cell has a laminate structure including a first electrode, a photoelectric conversion layer, and a second electrode,
the intermediate layer is not adhered to the main surface of the solar cell, and
a softening temperature T1 of a material of the intermediate layer is higher than a softening temperature T2 of a material of the first sealing layer.

2. The solar cell module according to claim 1, wherein the softening temperature T1 is higher than the softening temperature T2 by greater than or equal to 10°C.

3. The solar cell module according to claim 1 or 2, wherein a space exists between the intermediate layer and the second substrate.

4. The solar cell module according to any one of claims 1 to 3, further comprising a second sealing layer disposed between the intermediate layer and the second substrate, wherein
the softening temperature T1 is higher than a softening temperature T3 of a material of the second sealing layer.

5. The solar cell module according to any one of claims 1 to 4, wherein the intermediate layer contains glass or polyethylene.

6. The solar cell module according to any one of claims 1 to 5, wherein the photoelectric conversion layer contains a perovskite compound.

7. The solar cell module according to any one of claims 1 to 6, wherein the solar cell further includes an electron transport layer, and
the electron transport layer is disposed between the first electrode and the photoelectric conversion layer.

8. The solar cell module according to any one of claims 1 to 7, wherein the solar cell further includes a hole transport layer, and
the hole transport layer is disposed between the second electrode and the photoelectric conversion layer.

9. The solar cell module according to any one of claims 1 to 8, wherein the intermediate layer is fixed to the first sealing layer.

10. The solar cell module according to any one of claims 1 to 8, wherein the intermediate layer is fixed to the second substrate.
